Europäisches Patentamt

European Patent Office

Office européen des brevets

(11) Publication number: 0 481 559 A2

# EUROPEAN PATENT APPLICATION

(21) Application number: 91202634.1

(22) Date of filing: 10.10.91

(51) Int. Cl.5: H01L 29/784, H01L 29/08, H01L 29/10

(30) Priority: 18.10.90 US 599765

(43) Date of publication of application:
22.04.92 Bulletin 92/17

(84) Designated Contracting States:
DE ES FR GB IT NL

(71) Applicant: N.V. Philips' Gloeilampenfabrieken
Groenewoudseweg 1
NL-5621 BA Eindhoven(NL)

(72) Inventor: van Schravendijk, Bart
c/o INT. OCTROOIBUREAU B.V., Prof.
Holstlaan 6
NL-5656 AA Eindhoven(NL)
Inventor: McArthur, Douglas Cary
c/o INT. OCTROOIBUREAU B.V., Prof.
Holstlaan 6
NL-5656 AA Eindhoven(NL)
Inventor: de Jong, Jan Lodewijk
c/o INT. OCTROOIBUREAU B.V., Prof.
Holstlaan 6
NL-5656 AA Eindhoven(NL)

(74) Representative: Jilderda, Anne Ayolt et al
Internationaal Octrooibureau B.V. Prof.
Holstlaan 6 P.O. Box 220
NL-5600 AE Eindhoven(NL)

(54) A method of fabricating a field-effect transistor.

(57) In manufacturing a field-effect transistor structure, opposite-conductivity impurities are introduced into a semiconductor region (14) to form protection zones (26) and source/drain extensions (24). A shield (20 and 22) prevents the impurities from passing through the underlying section of the upper semiconductor surface (16). A further impurity is introduced into the semiconductor region to form main source/drain zones (34). A larger shield (20 and 32) prevents the further impurity from passing through the underlying section of the upper semiconductor surface. In the resultant FET structure, the final protection zones (26A) are fully surrounded along their lateral and lower surfaces either by the combined source/drain zones (34/24A) or by the combined zones and dielectric material (12). The final protection zones extend slightly under the gate electrode (20). The protection zones in combination with the final source/drain extensions (24A) substantially overcome the hot charge carrier effect.

FIG.1

This invention relates to semiconductor devices and, in particular, to the manufacture and structure of a field-effect transistor (FET) having a lightly doped drain (LDD) configuration.

An insulated-gate FET is a basic semiconductor device having a source and a drain formed in monocrystalline semiconductor material of opposite conductivity type to the source and drain. A channel laterally separates the source and drain along the upper surface of the semiconductor material. A gate dielectric layer, typically consisting of silicon dioxide when the semiconductor material is silicon, adjoins the semiconductor material above the channel. A gate electrode lies on the gate dielectric above the channel and normally extends slightly over the source and drain. If a suitable voltage is applied between the drain and source, charge carriers flow unidirectionally from the source to the drain depending on the value of a voltage applied between the gate electrode and source.

Reducing the size of the FET in order to save space and/or increase performance usually entails reducing the channel length -- i.e., the distance between source and drain. This leads to a troublesome phenomenon termed the "hot charge carrier effect".

More specifically, consider an N-channel FET in which the source-to-drain current consists of electrons. The electric field between the source and drain accelerates the electrons. Assuming that the supply voltage for an integrated circuit containing the FET is held constant so that the drain-to-source bias is approximately constant, decreasing the channel length causes the electric field to increase. In turn, the increased field causes many of the electrons to become very energetic or "hot" especially near the drain where the field is strongest.

Some of the hot electrons penetrate into the dielectric material, particularly the gate dielectric, near the drain and lodge in that material. More and more hot electrons lodge in the gate dielectric as usage of the FET increases. These trapped electrons slowly, but progressively, change the FET threshold voltage. In addition, hot electron damage at the semiconductor/dielectric interface reduces the quality of the gate dielectric. The performance of the circuit containing the FET decreases. Eventually, the trapped electrons can cause the circuit to fail.

A large number of techniques have been investigated for reducing or circumventing the hot charge carrier effect. For example, see Sanchez et al, "Drain Engineered Hot-Electron-Resistant Device Structures: A Review," IEEE Trans. Elec. Devs., June 1989, pp. 1125-1132. Also see Liou et al, "A 0.87-$\mu$m CMOS Technology for High-Performance ASIC Memory and Channelless Gate Array," IEEE JSSC, Apr. 1989, pp. 380-387, and Bampi et al, "A Modified Lightly Doped Drain Structure for VLSI MOSFET's," IEEE Trans. Elec. Devs., Nov. 1986, pp. 1769-1779.

One of the principal ways of attacking the hot carrier problem is to provide the drain with a lightly doped extension (of the same conductivity type). The lightly doped extension adjoins the main portion of the drain in the semiconductor material between the two source/drain (S/D) zones and normally extends to the upper semiconductor surface. Because the net doping in the extension is less than that in the main drain zone, the magnitude of the electric field in the vicinity of the drain is reduced. Fewer hot charge carriers are produced. Circuit degradation due to hot carrier trapping in the gate dielectric occurs more slowly.

In many integrated circuits, insulated-gate FETs are operated in the inverse mode. That is, the S/D zone that functions as the drain in one operation functions as the source in another operation, and vice versa. For this reason (among others), an LDD structure usually has a lightly doped extension for each main S/D zone. The lightly doped extensions penetrate slightly under the gate electrode, whereas the main S/D zones normally do not extend below the gate electrode.

As device dimensions continue to shrink, more reduction in the hot carrier effect is needed than what is achievable with lightly doped S/D extensions. In U.S. Patent 4,746,624, Cham et al disclose an N-channel FET that employs lightly doped buried S/D extensions in combination with lightly doped surface-adjoining S/D extensions. The buried S/D extensions are spaced further apart from each other than the surface-adjoining S/D extensions. The net N-type doping in the buried extensions lies between that in the main S/D zones and that in the surface-adjoining extensions. According to Cham et al, the buried extensions alleviate the hot carrier effect by causing the source-to-drain electron current to be deflected downward as the electrons approach the S/D zone that acts as the drain. Fewer hot electrons enter the gate dielectric.

Cham et al also disclose that their LDD structure may include a pair of high-resistance "blocking" zones which extend toward the channel more than the main S/D zones. The blocking zones lie within the surface-adjoining and buried extensions. However, the blocking zones do not extend under the gate electrode since they might pinch off the buried extensions and severely degrade device performance. The blocking zones are preferably intrinsic. However, they may be slightly P-type or slightly N-type. The purpose of the blocking zones is to further deflect the source-to-drain current downward near the drain.

In manufacturing their LDD structure, Cham et al first provide a gate electrode on a dielectric layer situated over the intended channel zone in a P-type silicon semiconductor substrate. The surface-adjoining S/D extensions are defined by ion implanting phosphorus using the gate electrode as an implantation shield. Dielectric spacers are provided along the sidewalls of the gate electrode. Next, the buried S/D extensions and blocking zones are defined by respectively implanting arsenic and boron difluoride using the gate electrode and dielectric spacers as an implantation shield. Cham et al then widen their dielectric spacers. Finally, the main S/D zones are defined by implanting a suitable impurity (apparently arsenic) using the gate electrode and widened spacers as an implantation shield.

Although the LDD FET of Cham et al may perform well, the fabrication process involves a relatively large number of steps. The spacers are created in two separate sets of operations separated by a doping step. There are four S/D doping steps when the blocking zones are utilized. Due to this relatively high level of complexity, device manufacturability can become a significant problem. It is desirable to have a simpler process for making a high-performance FET in which lightly doped surface--adjoining S/D extensions are used with other mechanisms to alleviate the hot carrier effect.

The present invention furnishes such a process and FET structure for substantially reducing the hot carrier problem.

More particularly, in accordance with the invention, a method of fabricating an FET starts with a structure containing a monocrystalline semiconductor region of a first conductivity type. A portion of the semiconductor region constitutes an intended channel for the FET. A first shield is formed at least partially over the semiconductor region along its upper surface generally above the intended channel. Formation of the shield normally includes providing a gate dielectric layer along the upper semiconductor surface. A patterned gate electrode is then created over the gate dielectric. In this case, the shield consists of at least the gate electrode and any dielectric material along its sidewalls.

A pair of impurities of opposite conductivity types are introduced into the semiconductor region through its upper surface. The shield substantially prevents the two impurities from passing through the directly underlying section of the upper semiconductor surface. As a result, a pair of laterally separated surface-adjoining S/D extension zones of a second conductivity type opposite to the first conductivity type are formed in the semiconductor region. A pair of corresponding laterally separated protection zones of the first conductivity type are also formed in the semiconductor region.

A second shield is formed over the semiconductor region at least partially along its upper surface generally above the intended channel. Along the length of the channel, the second shield has a greater width than the first shield. The shields are preferably concentric along their widths. Formation of the second shield normally involves providing dielectric spacers along the sidewalls of the gate electrode. The second shield then consists of at least the gate electrode and spacers.

A pair of laterally separated surface-adjoining main S/D zones of the second conductivity type are next created in the semiconductor region. The main S/D zones, which respectively correspond to the extension zones, are formed by introducing an impurity of the second conductivity type into the semiconductor region through its upper surface using the second shield to inhibit the impurity from passing through the directly underlying section of the upper semiconductor surface.

Each main S/D zone partially overlaps the corresponding extension zone. Consequently, each main zone forms a combined S/D zone of the second conductivity type with the corresponding extension zone. Also, the main zones are normally much more heavily doped than the remaining (non-overlapped) portions of the extension zones. At least part of each protection zone remains after the introduction of the second impurity so as to define a final protection zone of the first conductivity type. Each final protection zone is fully surrounded along its lateral and lower surfaces either by the corresponding combined S/D zone or by the corresponding combined S/D zone and dielectric material of the structure.

The second-mentioned shield-formation and doping steps are generally performed after the first-mentioned shield-formation and doping steps. If dielectric spacers constitute part of the second shield, the spacers are usually present in the final structure. However, the first-mentioned shield-formation and doping steps could be performed after the second-mentioned shield-formation and doping steps. This sequence can, for example, be achieved with a reverse-spacer technology in which dielectric spacers are provided along the gate electrode for the second-mentioned doping step and are subsequently removed for the first-mentioned doping step.

In the FET structure of the invention, the final protection zones deflect the source-to-drain current away from the gate dielectric. This helps to alleviate the hot carrier effect. The final S/D extension zones -- i.e., the portions of the extension zones not overlapped by the main S/D zones -- lower the electric field between the combined S/D zones to reduce the number of hot charge carriers that can lodge in the gate dielectric.

Importantly, in contrast to where the blocking zones of Cham et al are located, the final protection zones in the invention extend slightly under the gate electrode. This is critical positioning because the greatest number of hot charge carriers usually enter the parts of the gate dielectric located above the deflection zones and below the gate electrode. When any hot carriers are injected into these parts of the gate dielectric and get trapped there, the protection zones prevent the trapped carriers from causing undesired inversion in the underlying parts of the final S/D extension zones. As a result, the hot carrier problem is significantly reduced.

The change in device transconductance in the linear operating region as a function of usage time is the main parameter for estimating how well the hot carrier problem is overcome. The time for a 10% transconductance change is commonly termed the "hot electron lifetime". Increased hot electron lifetime is desired because it indicates that FET performance is changing more slowly.

The hot electron lifetime measured on experimental 0.5-micron N-channel FETs fabricated in accordance with the present invention is typically $1.2 \times 10^9$ seconds at the standard 5.5-volt drain-to-source bias. This is much greater than that reported in the available published literature (at the time of the filing of the present paper) for any other 0.5-micron FETs.

As the experimental evidence shows, the present FET overcomes the hot carrier problem better than any known prior art FET. The invention is also simple. In contrast to Cham et al, only one set of operations is needed to make the dielectric spacers used in the present invention. Only three S/D doping steps are necessary. There is no need for lightly doped buried S/D extensions of the type described in Cham et al. In short, the invention provides much better performance than the prior art and avoids unnecessary processing complexity.

Figs. 1a, 1b, 1c, 1d, 1e, 1f, 1g, 1h, and 1i are cross-sectional structural views illustrating steps in fabricating an N-channel insulated-gate FET structure in accordance with the invention.

Figs. 2a, 2b, 2c, and 2d are cross-sectional structural views taken respectively through planes 2a-2a, 2b-2b, 2c-2c, and 2d-2d in Figs. 1a, 1d, 1f, and 1h. In turn, these four figures are taken respectively through planes 1a-1a, 1d-1d, 1f-1f, and 1h-1h in Figs. 2a - 2d.

Like reference symbols are employed in the drawings and in the description of the preferred embodiments to represent the same or very similar item or items.

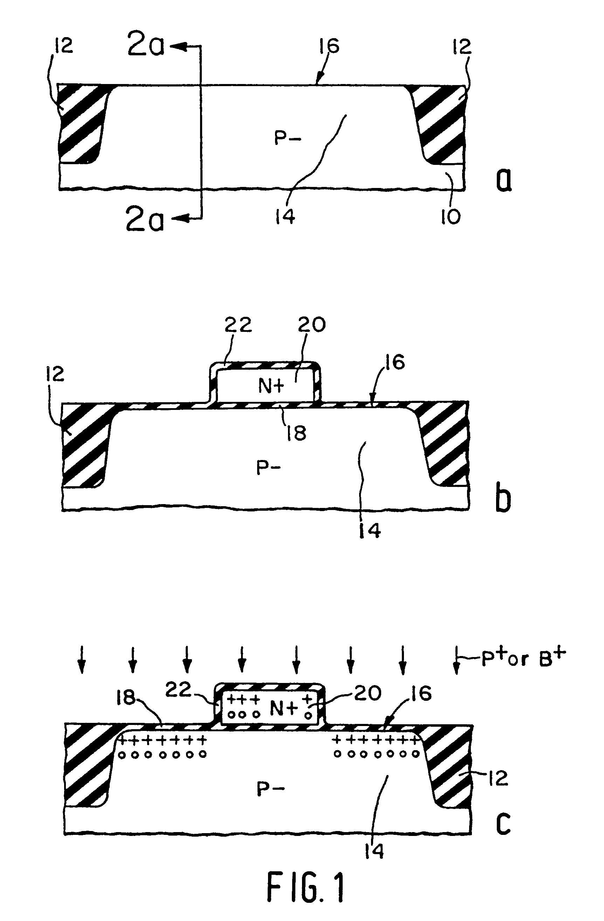

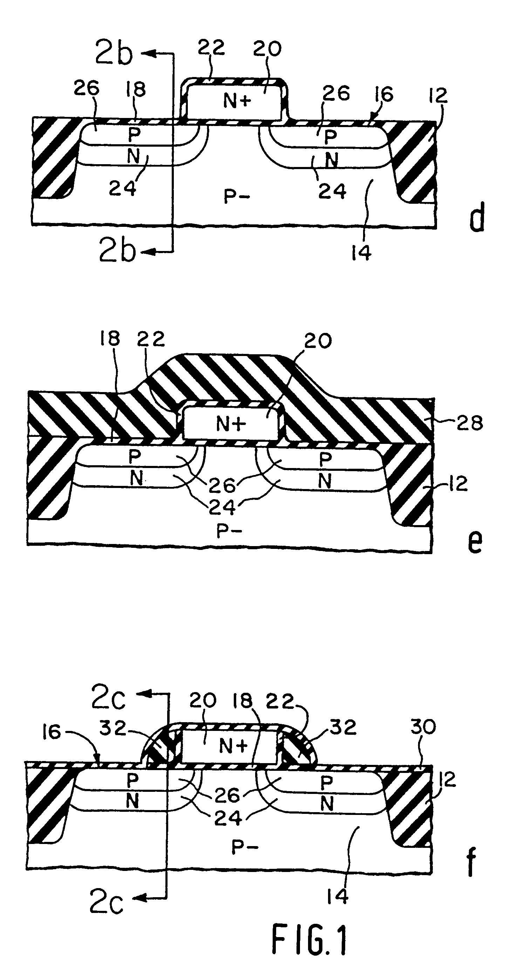

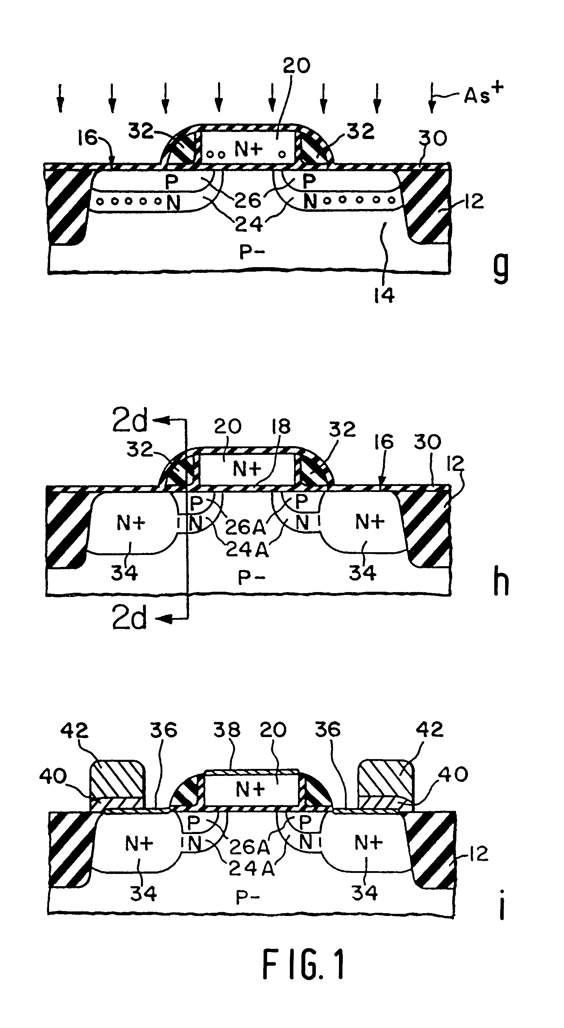

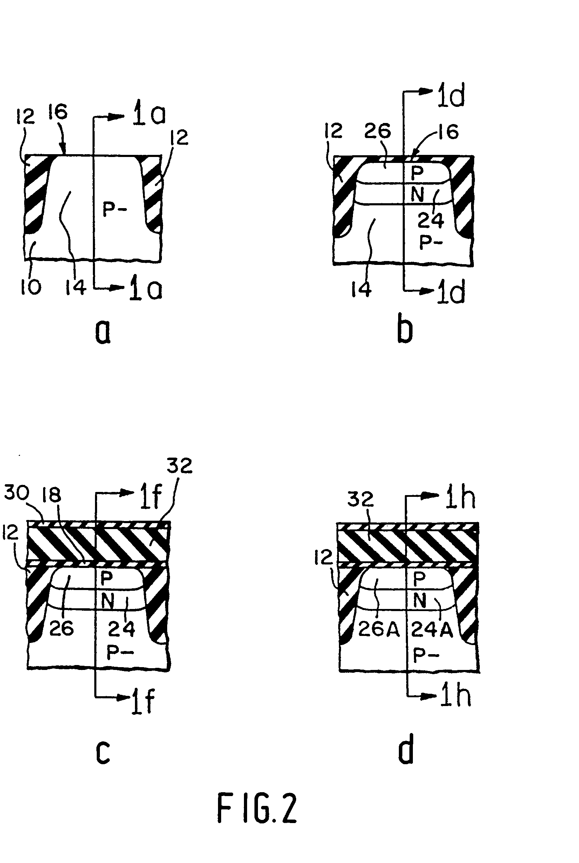

Referring to the drawings, Figs. 1a - 1i and 2a - 2d illustrate how an N-channel insulated-gate FET having lightly doped S/D extensions and opposite-conductivity protection zones is manufactured according to the teachings of the invention. The present manufacturing process typically forms part of an overall BiCMOS semiconductor fabrication process of the type described in de Jong et al, U.S. patent application Ser. No. 440,456, filed 20 November 1989, the contents of which are herein incorporated by reference.

Various ion implantations and high-temperature anneals are utilized in the invention. In addition to causing the implanted dopants to move to the locations described below, the anneals repair implant lattice damage and activate the implanted dopants.

As used in the following description, non-monocrystalline silicon (non-monosilicon) means polycrystalline silicon (polysilicon) or amorphous silicon. Due to the anneals and other high-temperature steps employed in the invention, any non-monosilicon portions that are initially deposited as amorphous silicon are invariable converted to polysilicon at the end of the process.

Conventional cleaning and photoresist masking techniques are used in the fabrication process. References to the cleaning steps, to the steps involved in photoresist mask making, and to other such well-known semiconductor processing steps are omitted from the manufacturing description to simplify the discussion. Non-consequential increases in oxide thickness are also generally omitted from the description for the same reasons.

The starting point for the invention is a semiconductor wafer containing a (100) monocrystalline silicon (monosilicon) semiconductor region 10 as shown in Figs. 1a and 2a. A recessed planarized annular field region 12 of silicon dioxide is provided on the wafer. Field-oxide region 12 laterally surrounds a generally rectangular surface-adjoining portion 14 of semiconductor region 10. Portion 14 constitutes an active semiconductor device region.

In a preferred method for achieving the structure of Figs. 1a and 2a, boron is selectively implanted into a lightly doped P-type (100) substrate. A lightly doped N-type epitaxial layer is grown on the substrate over the implanted boron. A field-oxide region is formed along the upper surface of the epitaxial layer according to the well-known LOCOS technique. The implanted boron diffuses upward during the creation of the field oxide, causing region 10/region 14 to become lightly doped P type. The field oxide is planarized in a conventional manner to convert it into field region 12.

P- region 14 has a relatively flat "upper" surface 16. The terms "upper", "lower", "side", "above", "below", "horizontal", "vertical", "lateral", and the like are defined (for convenience) with respect to the orientation of the structure when semiconductor surface 16 is generally parallel to the ground. Field-oxide region 12 extends about 1 micron into the structure below surface 16. P-region 14 has a "length" of about 5 microns in the horizontal direction in Fig. 1a and a "width" of 2 - 20 microns in the horizontal direction in Fig. 2a. Region 14 has a sheet resistance of 700 - 800 ohms/square.

A thin electrically insulating layer 18 of silicon dioxide is thermally grown along upper surface 16, causing surface 16 to be lowered slightly. See Fig. 1b. Using a thin non-monosilicon layer to prevent oxide layer 18 from being damaged, a pair of boron ion implantations are performed into P- region 14 to adjust the FET threshold voltage to about 0.8 volt and to inhibit source-to-drain punchthrough. The structure is then annealed in argon.

A thicker non-monosilicon layer is deposited on the thin non-monosilicon layer. The composite non-monosilicon layer is doped with arsenic and etched to form a heavily doped N-type gate electrode 20 on top of oxide layer 18. N+ non-monosilicon gate electrode 20 is spaced approximately equidistant from the portions of field oxide 12 shown in Fig. 1b. The thickness of gate electrode 20 is measured vertically, while its width is measured horizontally in Fig. 1b. Electrode 20 has a thickness of 0.3 - 0.4 micron and a width of about 1 micron. The sheet resistance of electrode 20 is about 150 ohms/square.

The portion of oxide layer 18 underlying gate electrode 20 constitutes the FET gate dielectric layer. Its thickness preferably is 200 angstroms. The gate dielectric layer lies over the intended channel for the FET. The portions of oxide layer 18 situated to the sides of electrode 20 are usually slightly thicker (e.g., 50 angstroms more) than the gate dielectric. An electrically insulating layer 22 of silicon dioxide having a thickness of about 350 angstroms is thermally grown along the sidewalls and upper surface of electrode 20.

Turning to Fig. 1c, phosphorus in the form of $P^+$ and boron in the form of $B^+$ are implanted through oxide layer 18 into P-region 14. Gate electrode 20 and the portions of oxide layer 22 along the (lateral) sidewalls of electrode 20 act as a shield to substantially prevent the two impurities from passing through the directly underlying section of upper surface 16. Field oxide 12 similarly prevents the implanted species from entering the directly underlying portion of P- region 10. The order in which the two implantations are performed is immaterial.

The phosphorus is implanted at an energy of 40 - 150 electron volts (KEV), preferably 100 KEV, and at a dosage of $1 \times 10^{13}$ - $5 \times 10^{14}$ ions/cm$^2$, preferably $6 \times 10^{13}$ ions/cm$^2$. The boron is implanted at an energy of 1 - 50 KEV, preferably 18 KEV, and at a dosage of $2 \times 10^{12}$ - $2 \times 10^{14}$ ions/cm$^2$, preferably $2.5 \times 10^{13}$ ions/cm$^2$. The "+" and the "o" symbols

in Fig. 1c respectively indicate the approximate locations of the peak boron and phosphorus implant concentrations at the end of the two implantations. Some of the boron and phosphorus enter N+ gate electrode 20 during the implantations. However, this does not have any significant effect on any part of electrode 20 since its original N-type doping concentration is quite high.

The structure is annealed for 10 - 120 minutes at 800 - 950°C in an inert gas environment. The preferred anneal temperature, time, and environment are 30 minutes, 875°C, and argon. The anneal drives the just-implanted phosphorus outward -- i.e., further into P- region 14 and also upward towards surface 16 -- to form a pair of laterally separated initial N-type S/D extension zones 24. See Figs. 1d and 2b. The anneal similarly drives the just-implanted boron outward to form a pair of laterally separated initial P-type protection zones 26 respectively corresponding to N extension zones 24.

N zones 24 extend slightly under gate electrode 20 where they reach upper surface 16. The channel length -- i.e., the distance between extension zones 24 --preferably is 0.5 micron. P protection zones 26 adjoin semiconductor surface 16 along substantially their entire upper surfaces and extend slightly under electrode 20. Importantly, as Figs. 1d and 2b together show, each P protection zone 26 is fully surrounded along its lateral and lower surfaces by field oxide 12 and the corresponding N extension 24.

A pair of dielectric spacers are now provided along the sidewalls of gate electrode 20 to an average spacer width considerably greater than the (average) thickness of the portions of oxide layer 22 along the sidewalls of electrode 20. Creation of the spacers involves first conformally depositing a thick electrically insulating layer 28 of silicon dioxide on the upper surface of the structure as shown in Fig. 1e. A conventional LPCVD technique is utilized to form oxide layer 28. Its thickness is about 0.5 micron.

An anisotropic etch is performed with a conventional plasma etchant such as a mixture of CHF$_3$ and CO$_2$ to remove substantially all the material of oxide layers 28, 22, and 18 not covered by gate electrode 20 except for a pair of small composite oxide portions that adjoin the sidewalls of electrode 20. Using a conventional LPCVD procedure, a thin electrically insulating layer 30 of silicon dioxide is deposited on the top of the structure. See Figs. 1f and 2c. Oxide layer 30 has a thickness of about 400 angstroms. The small remaining portions of oxide layers 28, 22, and 18 not covered by electrode 20 in combination with the portions of oxide layer 30 along the sides of the remaining parts of layer 28 constitute the spacers, generally labelled as items 32.

The width of dielectric spacers 32 is measured along the channel length at (approximately) one half their height. Both spacers 30 have largely the same width, the average spacer width being 0.3 - 0.4 micron. In contrast (as mentioned above), the thickness of the original sidewall portions of oxide layer 22 is about 350 angstroms.

Other techniques, such as thermal oxidation, could be used to create spacers 32 provided that their size is adequate for the implantation step described below. The minimum requirement on spacer width is that, along the channel length, the sum of the average total width of spacers 32 and the width of gate electrode 20 during the implantation and anneal steps described immediately after this paragraph must exceed the sum of the average total thickness of the sidewall portions of layer 22 and the width of electrode 20 during the immediately preceding implantation and anneal steps.

Arsenic in the form of $As^+$ is next implanted through oxide layer 30 into region 14 as shown in Fig. 1g. Gate electrode layer 20 and sidewall spacers 32 act as a shield to substantially prevent the arsenic from passing through the directly underlying section of upper surface 16. Again, field oxide 12 prevents the implanted species from entering any portion of region 10 directly underlying field oxide 12.

The arsenic is implanted at an energy of 30 - 200 KEV, preferably 150 KEV, and at a dosage of $1 \times 10^{15}$ - $1 \times 10^{16}$ ions/cm$^2$, preferably $2 \times 10^{15}$ ions/cm$^2$. The "o" symbols in Fig. 1g indicate the location of the peak arsenic implant concentration at the end of the implantation. Some of the arsenic also enters gate electrode 20 during the implantation.

The structure is annealed for 10 - 120 minutes at 800 - 950°C in an inert gas environment. The preferred anneal time, temperature, and environment are 30 minutes, 875°C, and argon. The anneal drives the just-implanted arsenic outward to form a pair of laterally separated heavily doped main N-type S/D zones 34 respectively corresponding to N zones 24. See Fig. 1h. The phosphorus and boron used to form zones 24 and 26 are driven slightly outward during this anneal.

Main N+ S/D zones 34 adjoin field oxide 12 along their sides most distant from gate electrode 20 and also along their sides running parallel to the channel length. Each main S/D zone 34 partially overlaps the corresponding S/D extension 24 so as to form a combined N-type S/D zone. Items 24A in Figs. 1h and 2d denote the remaining (moderately doped) non-overlapped portions of N extensions 24. N+ zones 34 have a much higher net average doping concentration than N zones 24A.

Each N+ zone 34 also partially overlaps the corresponding P protection zone 26. The N-type doping in S/D zones 34 is so high that they counterdope the portions of protection zones 26 where the overlap occurs. Items 26A in Figs. 1h and 2d indicate the remaining (non-overlapped) P-type portions of zones 26. Each final P protection zone 26A extends a small amount, typically 500 angstroms, under gate electrode 20.

Each P protection zone 26A is fully surrounded along its lateral and lower surfaces by field oxide 12 and the corresponding combined N-type S/D zone 34/24A. See Figs. 1h and 2d again. More precisely, zones 34/24A respectively adjoin zones 26A along their entire lateral and lower surfaces except along the lateral surfaces running parallel to the channel length where field oxide 12 adjoins zones 26A. Consequently, each protection zone 26A is fully isolated from the P-type material of region 14 or 10 outside the corresponding combined zone 34/24A.

The structure can now be finished in a conventional manner. For example, a first interconnect layer of an electrical interconnection system can be created by removing oxide layer 30 to expose N+ portions 20 and 34, providing layers 36 and 38 of a metal silicide such as platinum silicide along the respective upper surfaces of N+ portions 20 and 34, depositing a layer of barrier metal such as a titanium-tungsten alloy on the upper surface of the structure, depositing a layer of an aluminum alloy such as aluminum with 1% copper on the barrier metal, and etching the aluminum alloy and barrier metal using a suitable photoresist mask. Fig. 1i shows the resultant structure. Items 40 are the remaining portions of the barrier metal. Items 42 are the remaining portions of the aluminum alloy.

In the final device, N S/D extensions 24A reduce the magnitude of the maximum electric field that would otherwise occur near main N+ S/D zones 34. Fewer hot electrons are generated. P protection zones 26A deflect the source-to-drain electron current downward. The highest number of hot electrons enter the gate dielectric near the sides of gate electrode 20. Because protection zones 26A extend below electrode 20, they prevent hot electrons that lodge in the overlying parts of the gate dielectric from causing undesired charge inversion in the underlying parts of extensions 24A. The combination of these three phenomena substantially alleviates the hot carrier problem, as indicated by greatly increased hot electron lifetime.

While the invention has been described with reference to particular embodiments, this description is solely for the purpose of illustration and is not to be construed as limiting the scope of the invention claimed below. For example, semiconductor materials of opposite conductivity type to those described above could be used to achieve similar results in a P-channel insulated-gate FET. Dielectric materials such as silicon nitride could be used to form the spacers.

The requisite shapes and dopant concentrations of the deflection zones and the combined S/D zones could be achieved by using non-spacer shielding techniques. The combined S/D zones might not adjoin a field oxide region; as a result, each (initial or final) protection zone would be fully surrounded along its lateral and lower surfaces solely by the corresponding combined S/D zone. Various changes and modifications may thus be made by those skilled in the art without departing from the true scope and spirit of the invention as defined in the appended claims.

**Claims**

1. A method of fabricating a field-effect transistor from a structure in which there is a monocrystalline semiconductor region of a first conductivity type, a portion of the semiconductor region being an intended channel for the transistor, the method comprising the steps of:

   providing a first shield over the semiconductor region at least partially along its upper surface generally above the intended channel;

   introducing (a) a first impurity of the first conductivity type and (b) a first impurity of a second conductivity type opposite to the first conductivity type into the semiconductor region through its upper surface using the first shield to substantially prevent the first impurities from passing through the directly underlying section of the upper surface of the semiconductor region in order to form (a) a pair of laterally separated initial protection zones of the first conductivity type and (b) a pair of laterally separated surface-adjoining initial source/drain extension zones of the second conductivity type respectively corresponding to the initial protection zones;

   providing a second shield over the semiconductor region along its then-existing upper surface generally above the intended channel such that, along the length of the channel, the second shield has a greater width than the first shield; and

   introducing a second impurity of the second conductivity type into the semiconductor region through its then-existing upper surface using the second shield to substantially prevent the second impurity from passing through the directly underlying section of the then-existing upper surface of the semiconductor region in order to form a pair of laterally separated surface-adjoining main source/drain zones of the second conductivity type respectively corresponding to the initial extension zones, each main zone partially overlapping the corresponding extension zone after the four steps are completed to form a combined surface-adjoining source/drain zone of the second conductivity type, at least part of each initial protection zone remaining after the four steps are completed so as to define a final protection zone of the first conductivity type, each final protection zone being fully surrounded along its lateral and lower surfaces either by the corresponding combined zone or by the corresponding combined zone and dielectric material of the structure.

2. A method as in Claim 1 wherein the main zones have a much greater net average impurity concentration than the portions of the extension zones not overlapped by the main zones.

3. A method as in Claim 2 wherein the shields are largely concentric along their widths.

4. A method as in Claim 2 wherein the first-mentioned introducing step comprises ion implanting the first impurities into the semiconductor region and then annealing the structure to drive the first impurities further into the semiconductor region and also toward its upper surface.

5. A method as in Claim 4 wherein the second-mentioned introducing step comprises ion implanting the second impurity into the semiconductor region and then annealing the structure to drive the second impurity further into the semiconductor region and also towards its then-existing upper surface.

6. A method as in Claim 2 wherein the final protection zones laterally extend slightly under the gate electrode.

7. A method of fabricating a field-effect transistor from a structure that comprises (a) a monocrystalline semiconductor region of a first conductivity type, (b) a gate dielectric layer situated along an upper surface of the semiconductor region, and (c) a patterned gate electrode situated on the gate dielectric layer, the method comprising steps of:

   initially introducing (a) a first impurity of a first conductivity type and (b) a first impurity of a second conductivity type opposite to the first conductivity type into the semiconductor region through its upper surface using the gate electrode and any dielectric material along the sidewalls of the gate electrode as a shield to substantially prevent the first impurities from passing through the directly underlying section of the upper surface of the semiconductor region in order to form (a) a pair of laterally separated initial protection zones of the first conductivity type and (b) a pair of laterally separated initial source/drain extension zones respectively corresponding to the initial protection zones and extending to the upper surface of the semiconductor region;

subsequently providing dielectric spacers along the sidewalls of the gate electrode to an average width greater than the average thickness of any dielectric material along the sidewalls of the gate electrode during the initial introducing step; and

further introducing a second impurity of the second conductivity type into the semiconductor region through its then-existing upper surface using the gate electrode and the spacers as a shield to substantially prevent the second impurity from passing through the directly underlying section of the then-existing upper surface of the semiconductor region in order to form a pair of laterally separated main source/drain zones of the second conductivity type respectively corresponding to the initial extension zones and extending to the then-existing upper surface of the semiconductor region, each main zone partially overlapping the corresponding extension zone to form a combined source/drain zone of the second conductivity type, at least part of each protection zone remaining after the further introducing step so as to define a final protection zone of the first conductivity type, each final protection zone being fully surrounded along its lateral and lower surfaces either by the corresponding combined zone or by the corresponding combined zone and dielectric material of the structure.

8. A method as in Claim 7 wherein the main zones have a much greater net average impurity concentration than the portions of the extension zones not overlapped by the main zones.

9. A method as in Claim 8 wherein the final protection zones laterally extend slightly under the gate electrode.

10. A field-effect transistor formed out of a structure that comprises (a) a monocrystalline semiconductor region principally comprising semiconductor material of a first conductivity type and having an upper semiconductor surface, (b) a gate dielectric layer situated along the upper semiconductor surface, and (c) a patterned gate electrode situated over the gate dielectric layer, the semiconductor region including:

a pair of main source/drain zones of a second conductivity type opposite to the first conductivity type laterally separated by semiconductor material below the gate electrode and extending to the upper semiconductor surface;

a pair of source/drain extension zones of the second conductivity type laterally separated by semiconductor material below the gate electrode, laterally extending slightly under the gate electrode where they reach the upper semiconductor surface, respectively corresponding to the main zones, and having a lower net average doping concentration than the main zones, each main zone partially overlapping the corresponding extension zone so as to form a combined source/drain zone of the second conductivity type; and

a pair of source/drain protection zones of the first conductivity type laterally separated by semiconductor material below the gate electrode, extending to the upper semiconductor surface and slightly under the gate electrode, and respectively corresponding to the combined zones, each protection zone being fully surrounded along its lateral and lower surfaces either by the corresponding combined zone or by the corresponding combined zone and dielectric material of the structure.

FIG. 1

FIG.1

FIG. 1

FIG.2